# NEW EUROPEAN PATENT SPECIFICATION

(11) **EP 0 006 706 B2**
(45) Date of publication and mention of the opposition decision: **17.03.1993**
(45) Mention of the grant of the patent: 30.10.1985
(21) Application number: 79301114.9
(22) Date of filing: 12.06.1979
(51) Int. Cl.: H01L 21/318, H01L 21/314, H01L 21/28, H01L 29/46, H01L 29/62

(54) **Process for producing a semiconductor device having an insulating layer of silicon dioxide covered by a film of silicon oxynitride**
Verfahren zur Herstellung einer Halbleiteranordnung mit einer Isolierschicht aus Siliziumdioxid, die mit einer Schicht aus Siliziumoxynitrid bedeckt ist
Procédé pour la fabrication d'un dispositif semiconducteur, muni d'une couche isolante de dioxyde de silicium recouverte d'une couche d'oxynitrure de silicium

(30) Priority: 14.06.1978 JP 71618/78; 15.06.1978 JP 72654/78
(43) Date of publication of application: 09.01.1980
(60) Divisional application: 82201230.8
(73) Proprietor: FUJITSU LIMITED, Kawasaki-shi, Kanagawa 211 (JP)
(72) Inventor: Ito, Takashi, Kawasaki-chi Kanagawa 214 (JP); Nozaki, Takao, Yokohama-shi Kanagawa 227 (JP)
(74) Representative: Rackham, Stephen Neil

(56) References cited:
- DE-A- 1 644 012
- DE-C- 1 489 188
- FR-A- 2 223 836
- US-A- 3 385 729
- US-A- 3 520 722
- US-A- 3 798 061
- US-A- 4 056 642
- JOURNAL OF THE ELECTROCHEMICAL SOCIETY, vol. 123, no. 7, July 1976. Princeton (USA) E. KOOI et al. "Formation of silicon nitride at a Si-SiO2 interface during local oxidation of silicon and during heat-treatment of oxidized silicon in NH3 gas" pages 1117-1120
- IBM T.D.B. vol. 10, no. 3, August 1976, New York M.R. POPONIAK et al. "Formation of thick Si3N4 ot SixOyNz on Si substrate by anodnitridization" page 905
- IBM-Technical Disclosure Bulletin, Vol. 17, No. 8, Jan 1975, p. 2330
- Journal of the Electrochemical Society, Vol. 120, No. 9, 1973, 1225-1229
- Philips Journal of research, vol. 38, no. 1/2, 1983, pages 19-36

## Description

The present invention relates to a process for producing a semiconductor device according to the first part of claim 1. Such a process is known from IBM-Technical Disclosure Bulletin, Vol. 19, No.3, Aug. 1976, p.905.

Materials that have been used as insulating films in silicon semiconductor devices in the past include silicon dioxide (Si0₂), silicon nitride (Si₃N₄) and silicon oxynitride (SiOₓNy). Silicon dioxide is usually formed by a thermal oxidation of the silicon substrate or CVD or controlled vapour deposition process and thus, is inherently not dense. Silicon nitride has always been formed by CVD (chemical vapor deposition) process or by directly nitridating silicon. Silicon oxynitride has been formed by a CVD process using NH₃, 0₂ and SiH₄ gases.

It is also known to use a double film, wherein alumina (A1₂0₃), silicon nitride or a mixture of A1₂0₃ and Si₃N₄ is applied or laminated on a silicon dioxide film. The known insulating single or double film is, however, unstable during the production or operation of the semiconductor device, and does not have a dense structure. Furthermore, it is inevitable that an interface is caused between the insulating film and the silicon substrate when it is applied by the CVD process.

In a further known CVD process for producing silicon oxynitride, monosilane (SiH₄), ammonia (NH₃) and oxygen (0₂) are brought into reaction with each other at a temperature of, for example, 700°C; see also FR-A- 2 223 836. The molar ratio of ammonia with respect to oxygen may be varied or changed gradually during the CVD period. However, the silicon oxynitride produced by this CVD process possesses structural defects. The inventors of the present invention believe that the structural defects are caused by the fact that intermediate reaction products of the CVD reaction are incorporated into the insulation film.

Afurther disadvantage of the CVD process mentioned above is that it is difficult precisely to adjust the thickness of the silicon oxynitride film, and to form a film having a thickness of 10 nm or less.

It is well known in the field of semiconductor devices to use silicon dioxide (Si0₂) as an insulating film on a semiconductor silicon substrate. Since the semiconductor device is required to operate both reliably and stably for a long period of time, contamination of the semiconductor substrate surface, which is believed to be the major reason for deterioration in its reliability, is prevented by covering the surface of the semiconductor substrate with a silicon dioxide film. Silicon dioxide is the insulating material which is most frequently used for such covering, namely for surface passivation.

It is also known that a single film of silicon dioxide cannot effectively prevent the surface of the semiconductor substrate from being contaminated by contaminants, such as moisture or sodium ions, from outside the semiconductor device. Accordingly, an upper film of alumina (A1₂0₃) is sometimes applied on the film of silicon dioxide. Instead of the alumina film, a phosphorus glass layer, a boron glass layer or a lead glass layer may be formed on the silicon dioxide film. The formation of the phosphorus glass layer or phosphorus treatment can be simply carried out and effectively passivates the semiconductor surface. Although the phosphorus treatment is most frequently used in the industrial production of semiconductor devices, the surface of the passivation film, on which the phosphorus is impregnated, is hygroscopic and, hence, unstable.

It is also known that the silicon dioxide film, which can be formed by directly oxidising the silicon substrate, is superior to an insulating film directly, deposited on the silicon substrate by the CVD process. This is because the CVD process involves a contamination of the interface between the film and substrate due to vapour sources.

IBM Technical Disclosure Bulletin, Vol. 17, No. 8, January 1975, p.2339 discloses a MISFET device having a multilayered gate insulation film formed from a layer of thermal silicon dioxide covered by a film of silicon oxynitride. The layer of silicon dioxide has a thickness of about 10nm.

US-A-3385729 (Larchian) discloses a dielectric structure for isolating semiconductor devices on a common substrate. The dielectric is produced by thermally growing silicon dioxide on the substrate and then nitriding the surface of the silicon dioxide in an ammonia atmosphere at a temperature of 1200°C. The silicon dioxide film is typically 800 to 1200 nm thick.

DE-A-1664012 discloses a process for forming a diffusion mask made of silicon nitride on a silicon substrate. A continuous silicon nitride film is formed by thermal nitridation of the substrate and portions thereof corresponding to the windows of the diffusion mask are converted to silicon dioxide by oxidation and removed by selective etching.

It is, therefore, an object of the present invention as claimed to provide a dense insulating film for semiconductor devices which does not have the disadvantages of the conventional insulating films.

Accordingly the invention concerns a process for producing a semiconductor device, having an insulating film having a film of silicon dioxide covered by a film of silicon oxynitride, comprising the steps of forming an exposed film of silicon dioxide and heating said silicon dioxide film in a nitriding atmosphere, characterised in that the silicon dioxide film has a thickness between 3 and 70nm and the silicon oxynitride insulating film is formed by heating at 900 to 1300°C in a nitriding atmosphere that consists of 100% ammonia, optionally together with inert gas, and in that the silicon dioxide film is made by the preliminary step of forming a silicon nitride surface film by thermal nitridation of a silicon surface layer of a silicon substrate and converting the exposed surface of the silicon nitride film to silicon dioxide by oxidation.

The insulating film so formed according to this invention comprises a so called silicon oxynitride, which is a silicon dioxide in which oxygen atoms are replaced, although not stoichiometrically, by nitrogen atoms. The silicon oxynitride formed by the present invention is distinguished from the known silicon oxynitride, formed by a CVD process using NH₃, SiH₄ and 0₂ gases since a film of silicon dioxide is subjected to a nitridating step in accordance with the present invention. The silicon oxynitride film produced according to the present invention is also distinguished from the known, double structure film of a lower, silicon dioxide layerand an upper, silicon nitride layer, because in the known structure, the silicon nitride layer is deposited on the silicon dioxide layer whilst in the present invention the silicon dioxide layer is partly nitrided or impregnated with nitrogen. Accordingly, the insulating film made in accordance with the present invention does not have the disadvantages, such as the formation of structural defects therein and contamination of the interface between such a film and the semiconductor silicon substrate.

It is known to form a silicon dioxide film by thermal oxidation of a semiconductor silicon substrate this comprises the step of heating the substrate to an elevated temperature of from 600 to 1200°C in an oxidising atmosphere of, for example, oxygen or water. Depending on the purpose of the silicon dioxide film, the thickness of the film is selected to be in the range of from 3 to 2000 nm.

The thermal oxidation of silicon is suitable for preventing the increase of electric charges on the surface of the silicon substrate to a level of more than 1 0¹2_{cm} -_{2.}

The nitridation process of silicon dioxide film according to the present invention comprises the preliminary step of forming a silicon nitride surface film on the substrate and a subsequent step of heating the semiconductor silicon substrate and the silicon dioxide film formed on the substrate to a temperature of from 900 to 1300°C, preferably from 1000 to 1200°C in an atmosphere which consists of 100% ammonia (NH₃). The nitridation atmosphere may also contain an inert gas such as argon. The flow rate of the gas should be from 100 to 50000 cc/minute. The nitridation time should be at least 1 minute. The maximum nitridation time is dependent upon the extent of the desired nitridation. Thus, the nitridation time is increased when nitrogen is to be introduced to a large depth in the silicon dioxide film, and/orwhen the molar ratio of nitrogen to oxygen in the nitrided film is required to be high. The inventors believe that nitrogen atoms in the nascent state are formed from the decomposition of the ammonium which atoms participate in the formation of the silicon oxynitride. Since experiments by the inventors have shown that no silicon oxynitride was formed by the heat treatment using molecular nitrogen gas, it is essential to use NH₃.

The process for forming a direct thermal nitride film of silicon may comprise a step of heating the silicon substrate in a nitrogen containing atmosphere to a temperature of from 900 to 1300°C, preferably from 1000 to 1200°C for a period of from 0.01 to 100 hours. The nitriding atmosphere may comprise a nitrogen compound, such as ammonia or hydrazine (N₂H₄). The nitrogen compound is preferably ammonia. The direct thermal nitride film of silicon preferably has thickness of from 2 to 10 nm, more preferably from 3 to 5 nm. Such a nitride film can be formed by using a nitridation atmosphere in which oxidant implurities, such as oxygen, water, carbon dioxide, etc., are reduced to a level of less than 100 ppm and by adjusting the nitridation temperature to a range of from 1200 to 1300°C.

It is preferable to completely clean the silicon substrate prior to the nitridation, by degreasing the silicon substrate in an inorganic solvent, boiling in a acid solution, preferably sulfuric and nitric acid, and etching in hydrofluoric acid. Prior to forming the direct thermal nitride film or silicon, it is preferable to heat the silicon substrate in an inert gas atmosphere at temperature of from 900 to 1300°C.

The oxidation step may comprise heating the semiconductor silicon substrate provided with the nitride film to a temperature of from 500 to 1300°C, preferably from 900 to 1200°C, in an oxidizing atmosphere of oxygen or water. The film consisting essentially of silicon nitride is gradually changed to silicon oxide by oxygen atoms, which diffuse from the surface to the interior of the film. Silicon oxide or silicon oxynitride is, therefore, formed on the oxidized surface of the film. In the oxidation step mentioned above, the thickness of the oxidized, silicon nitride film is increased because the oxide film grows to the thickness of from 3 to 19 nm, preferably from 5 to 9 nm. The total thickness of the silicon nitride and the oxydized film in increased from the thickness of the nitride film directly after the thermal nitridation of silicon.

The final nitridation step of the oxidized surface of the nitride film for the formation of siliconoxynitride is carried out as stated above.

The insulation film comprising the silicon oxynitride produced according to the present invention are not liable to contamination by impurities, such as moisture, and sodium and potassium ions. The surface state density (Nₛₛ) of the insulation film is decreased considerably by the nitridation of silicon dioxide to a level of approximately 5x10¹¹ to 1x1010/cm2 at a silicon surface potential of 0.3eV. It is believed by the Inventors that, because of the decrease in the drift of sodium ions due the nitridation, the behaviour of the capacitance change depending upon the voltage applied to the insulation film is decisively influenced by injection of carriers into a trap level, which is present in the proximity of the interface between the silicon substrate and the insulation film comprising the silicon dioxide.

In the nitridation for the formation of siliconoxynitride it is preferable to select the heating time in the range of from 1 to 5 hours and the heating temperature in the range of from 1000 to 1200°C, so as to provide the insulation film with a low Nₛₛ.

Under a high electric potential, the insulation films produced according to the present invention do not exhibit such disadvantageous behaviors as the movement of ions and the capturing phenomena of carriers in the film.

The insulation film comprising the silicon oxynitride produced according to the present invention, has a high relative dielectric constant ranging from 4 to 5.3. Furthermore, the insulation films produced according to the present invention have a high breakdown voltage in the range offrom 11 to 12 MV/cm. The breakdown voltage is increased as the nitridation time increases.

The silicon oxynitride film is highly resistant against etching solutions used in the production of semiconductor devices, such as hydrofluoric acid, ammonium floric acid and their mixed solution. The resistance against etching solution is increased with an increase in the nitridation time.

The insulative film, which is formed by a nitridation of the thermally oxidized silicon substrate, has such a structure that this oxidation film is gradually converted to silicon oxynitride from the surface to the interior of this film. In other words, at least an upper surface of the insulative film comprises a silicon oxynitride, and the nitrogen content of the silicon oxynitride is gradually decreased from the surface to the interior thereof. Accordingly, the insulative film produced according to the present invention is dense and includes no structural defects, which are liable to form at the interface of the laminated structure of two different kinds of layers.

The insulative film, which is formed by successive direct thermal nitridation, oxidation and the final nitridation steps according to a particular embodiment of the invention, may have a structure different from that described above, but it is dense and includes no structural defects.

The molar ratio of nitrogen to oxygen in the silicon oxynitride generally ranges from 1:10 to 10:1.

The insulative films produced according to the present invention present no such inconveniences as: contamination of the interface between the semiconductor substrate and the film due to the formation of the film, and; polarization of carriers in the films caused by the electric field. Property variation of the insulative films due to movable ions is favourably suppressed by the nitridation of the silicon dioxide.

Because of the facts mentioned above, the insulative films produced according to an embodiment of the present invention are suitable for use as a passivation film of a semiconductor device, as a gate insulation film of a MISFET, as a mask against selective diffusion of impurities into a semiconductor silicon substrate, or as the dielectric of a capacitor in a semiconductor device such as a memory cell.

When a dense insulating film in the range of from approximately 3 to 18 nm is desired for one of the mentioned uses, the direct thermal nitridation of the substrate, thermal oxidation of the silicon nitride and final nitridation of the silicon oxide should be performed successively. The direct thermal nitridation should be performed in such a mannerthatthe nitride film grows to a thickness of from approximately 2 to 10 nm, preferably from 3 to 7 nm. The thermal oxidation time should be from approximately 0.01 to 100 hours, preferably from 0.1 to 10 hours. The nitridation afterthe thermal oxidation step should be carried out from approximately 0.01 to 100 hours, preferably from 0.1 to 10 hours.

## Claims

1. A process for producing a semiconductor device, having an insulating film having a film of silicon dioxide covered by a film of silicon oxynitride, comprising the steps of forming an exposed film of silicon dioxide and heating said silicon dioxide film in a nitriding atmosphere, characterised in that the silicon dioxide film has a thickness between 3 and 70nm and the silicon oxynitride insulating film is formed by heating at 900 to 1300°C in a nitriding atmosphere that consists of 100% ammonia, optionally together with inert gas, and in that the silicon dioxide film is made by the preliminary step of forming a silicon nitride surface film by thermal nitridation of a silicon surface layer of a silicon substrate and converting the exposed surface of the silicon nitride film to silicon dioxide by oxidation.

2. A process according to claim 1 characterised in the silicon oxynitride is formed to a thickness of 3 to 18nm.

3. A process according to either preceding claim characterised in that the silicon oxynitride film is formed to a thickness of approximately 3nm.

4. A process according to any preceding claim characterised in that the silicon nitride surface film is formed by heating the silicon substrate to a temperature of 900 to 1300°C in a nitrogen-containing atmosphere with an oxidant impurity in an amount of less than 100ppm and the oxidation of the exposed surface of the silicon nitride film to silicon dioxide is effected by heating the silicon nitride film in an oxidising atmosphere at a temperature of 900 to 1300°C.

5. A process according to any preceding claim characterised in that the nitridating atmosphere consists only of 100% ammonia.

## Patentansprüche

1. Verfahren zur Herstellung einer Halbleitervorrichtung, mit einem isolierenden film, welcher einen aus Siliziumdioxidfilm umfaßt, der von einem Siliziumoxinitridfilm bedeckt ist, mit den Schritten der Bildung eines exponierten Siliziumdioxidfilms und Erhitzen des Siliziumdioxidfilms in einer nitrierenden Atmosphäre, dadurch gekennzeichnet, daß der Siliziumdioxidfilm eine Dicke zwischen 3 und 70 nm hat und der film aus Siliziumoxinitrid durch Erhitzen auf 900 bis 1300°C in einer nitrierenden Atmosphäre gebildet wird, welche aus 100% Ammoniak besteht, wahlweise zusammen mit einem inerten gas, und daß der Siliziumdioxidfilm durch den vorläufigen Schritt der Bildung eines Siliziumnitridoberflächenfilms durch thermisches Nitrieren einer Siliziumoberflächenschicht von einem Siliziumsubstrat und Konvertieren der exponierten Oberfläche des Siliziumnitridfilms durch Oxidation zu Siliziumdioxid.

2. Verfahren nach Anspruch 1, dadurch gekennzeichnet, daß das Siliziumoxynitrid zu einer Dicke von 3 bis 18 nm geformt ist.

3. Verfahren nach einem der vorhergehenden Ansprüche, dadurch gekennzeichnet, daß der Siliziumoxinitridfilm zu einer Dicke von etwa 3 nm geformt ist.

4. Verfahren nach einem der vorhergehenden Ansprüche, dadurcah gekennzeichnet, daß der Siliziumnitridoberflächenfilm durch Erhitzen des Siliziumsubstrats auf eine Temperatur von 900 bis 1300 °C in einer sticksoffhaltigen Atmosphäre mit einer oxidierenden Verunreinigung in einem Betrag von weniger als 100 ppm geformt wird, und die Oxidation der exponierten Oberfläche des Siliziumnitridfilms zu Siliziummdidoxid durch Erhitzen des Nitridfilms in einer oxidierenden Atmosphäre auf eine Temperatur von 900 bis 1300°C bewirkt wird.

5. Verfahren nach einem der vorhergehenden Ansprüche, dadurch gekennzeichnet, daß die nitrierende Atmosphäre lediglich aus 100% Ammoniak besteht.

## Revendications

1. Procédé de production d'un dispositif semiconducteur présentant un film isolant comportant un film de dioxyde de silicium recouvert par un film d'oxynitrure de silicium, comprenant les étapes consistant à former un film exposé de dioxyde de silicium et à chauffer ledit film de dioxyde de silicium dans une atmosphère nitrurante, caractérisé en ce que le film de dioxyde de silicium a une épaisseur comprise entre 3 et 70 nm et le film isolant d'oxynitrure de silicium est formé par chauffage à une température de 900 à 1300°C dans une atmosphère nitrurante qui consiste en ammoniac à 100%, éventuellement avec un gaz inerte, et en ce que le film de dioxyde de silicium est formé par l'étape préliminaire consistant à former un film superficiel de nitrate de silicium par nitruration thermique d'une couche superficielle de silicium d'un substrat de silicium et à convertir la surface exposée du film de nitrure de silicium en dioxyde de silicium par oxydation.

2. Procédé selon la revendication 1, caractérisé en ce que l'oxynitrure de silicium est formé sur une épaisseur de 3 à 18 nm.

3. Procédé selon l'une quelconque des revendications précédentes, caractérisé en ce que le film d'oxynitrure de silicium est formé sur une épaisseur d'environ 3 nm.

4. Procédé selon l'une quelconque des revendications précédentes, caractérisé en ce que le film superficiel de nitrure de silicium est formé par chauffage du substrat de silicium à une température de 900 à 1300°C dans une atmosphère contenant de l'azote avec une impureté oxydante en une quantité inférieure à 100 ppm et l'oxydation de la surface exposée du film de nitrure de silicium en dioxyde de silicium est réalisée par chauffage du film de nitrure de silicium dans une atmosphère oxydante à une température de 900 à 1300°C.

5. Procédé selon l'une quelconque des revendications précédentes, caractérisé en ce que l'atmosphère nitrurante consiste uniquement en ammoniac à 100 %.
